# EUROPEAN PATENT APPLICATION

(11) **EP 4 013 196 A1**
(43) Date of publication of application: **15.06.2022**
(21) Application number: 19947320.8
(22) Date of filing: 26.09.2019
(51) Int. Cl.: H05K 3/34, B23K 1/00, B23K 1/005

(54) **LASER SOLDERING METHOD AND DEVICE**

(71) Applicant: O.M.C. Co., Ltd., Takatsuki-shi, Osaka 569-1026 (JP)
(72) Inventor: WATANABE Shinji, Takatsuki-shi, Osaka 569-1026 (JP)
(74) Representative: Horn Kleimann Waitzhofer Patentanwälte PartG mbB
(86) International application number: PCT/JP2019/037997
(87) International publication number: WO 2021/059456

(57) **Abstract**

A hot wind (N) is blown to a land (42) and a lead (52) from the underside of a printed board (40), to perform preheating. At the start of preheating or after start of preheating, a laser beam (L) is applied to a soldering point, and meanwhile, wire solder (15) is fed to a position contacting with the soldering point. The fed wire solder (15) is melted by the laser beam (L). After soldering is finished, feeding of the wire solder (15) is stopped. Application of the laser beam (L) is stopped, to solidify the melted solder (15m).

## Description

### Technical Field

The present invention relates to a laser soldering method for performing soldering by using a laser beam, and a laser soldering device used for performing the laser soldering method.

### Background Art

In general, reflow soldering is often used for mounting electronic components in mass production. In typical reflow soldering, each lead of electronic components is placed on a pad of a printed board on which solder paste has been applied, and then the printed board is passed through the inside of a reflow oven, to melt the solder, whereby each lead of electronic components and the corresponding pad on the printed board are soldered and joined.

In such reflow soldering, since the printed board is heated in the reflow oven, there is a problem that thermal strain or deformation occurs.

Therefore, a system for replacing such reflow soldering with laser soldering has been paid attention to recently.

In a conventional laser soldering device, electronic components are mounted at an upper surface of a printed board to be soldered, and a laser beam is emitted from an emission head placed above the printed board toward a soldering point (land and lead) exposed between the electronic components. Wire solder is fed to the soldering point. The wire solder having reached the laser irradiated area is sequentially melted, and the melted solder drops to adhere to the land and the lead on the upper surface side of the printed board and also to flow downward through a gap between the land and the lead to come around to the lower surface side of the printed board. Then, the solder solidifies to form proper conical solder layers around the lead on both upper and lower surfaces of the printed board.

In the laser soldering, a laser beam is focused and applied to a fine spot, whereby contactless and local soldering can be performed and also thermal strain of the printed board can be avoided. In addition, the laser soldering is considered advantageous for automation of soldering work.

However, as printed boards are further highly integrated, a space cannot be secured between electronic components, so that it has become impossible to apply a laser beam from the upper surface side of the printed board on which electronic components are mounted as in the conventional method.

Accordingly, as shown in Patent Document 1, it has been proposed that a printed board is turned upside down to set the electronic component mounting surface on the lower side, and while wire solder is fed to a lead of an electronic component protruding upward from a through hole of the printed board, and a land of the through hole, a laser beam is applied thereto from the upper side of the printed board, thereby performing soldering.

### Citation List

### Patent Documents

Patent Document 1: JP 2013-187411 A

### Summary of Invention

### Technical Problem

However, if the printed board is turned upside down and electronic components are placed on the lower surface side, in this state, the electronic components drop. Therefore, when turning the printed board, it is necessary to provide a jig for fixing the mounted electronic components to the printed board while keeping their positional relationship, thus causing a problem of complicating soldering work.

In addition, it is necessary to preheat the land and the lead at the soldering point to a temperature close to the melting temperature of the solder, in advance of soldering. In a state in which the land and the lead of the electronic component are not preheated and thus have a low temperature, when the solder melted by the laser beam contacts with the lead or the land in the lowtemperature state, the solder immediately solidifies, so that adhesion thereof is lost, leading to soldering fault.

However, in the case where the laser beam is applied to the soldering point for the preheating, when the output of the laser beam is increased for melting the wire solder following the preheating, the lead is overheated and discolored, thus causing "lead burn".

Accordingly, in Patent Document 1, the land on the irradiation side is divided into a first land including a through hole where a lead is to be fixed by soldering, and a second land that is provided in an area extending from the first land and where melted solder is fed to flow into the first land, and the laser beam irradiation state is divided into a first irradiation state in which the laser beam is applied to only the second land and a second irradiation state in which the laser beam is applied to the first land, so as to be switchable therebetween.

In this method, a space for providing the second land extending from the first land is needed. On the highly dense printed board as described above, such a space for the second land cannot be provided even on the lower surface side. In addition, operation of dividing the irradiation state into the first irradiation state and the second irradiation state and switching therebetween and a work of feeding melted solder at the second land to flow into the first land as described above, are complicated, and also, for soldering, the first land and the lead need to be preheated by a laser beam from this point of time. Thus, the takt time of work is prolonged.

Accordingly, the inventors have conceived of feeding wire solder from the underside obliquely upward toward a soldering point on the lower surface side of a printed board (a land on the lower surface side and a lead protruding from the land) and applying a laser beam to this part. However, in this method, firstly, fume generated at the time of soldering or a fine particle (solder ball) spattered from the solder surface when the solder is melted might drop to adhere to protection glass provided to a laser emission window of an emission head placed under the printed board, thus rapidly contaminating the protection glass.

The present invention has been made in view of the above problems, and an object thereof is to develop a laser soldering method and a laser soldering device that, firstly, can perform soldering from the underside of the printed board, which has been conventionally considered impossible, and secondly, can shorten a takt time for soldering work as much as possible on an ultra-large-scale integrated printed board.

### Solution to Problem

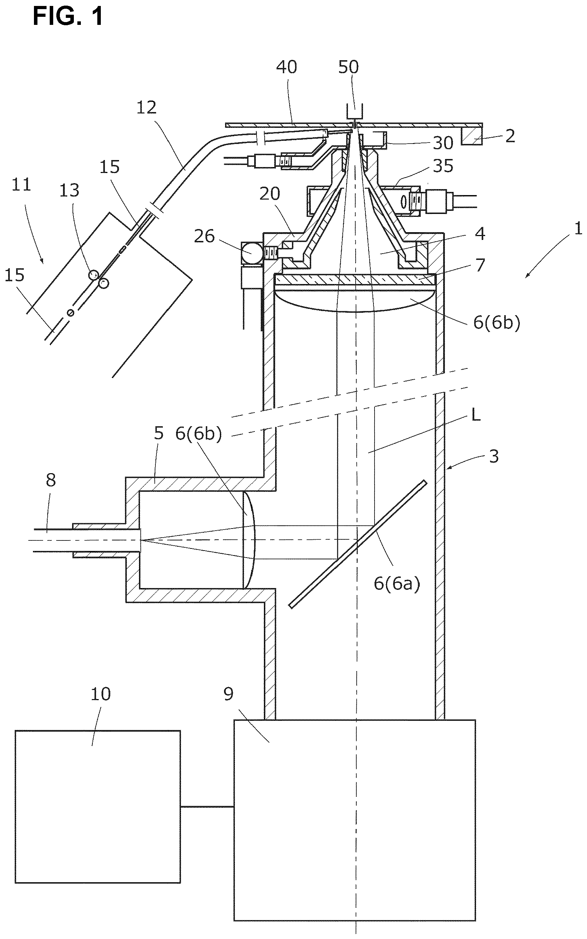

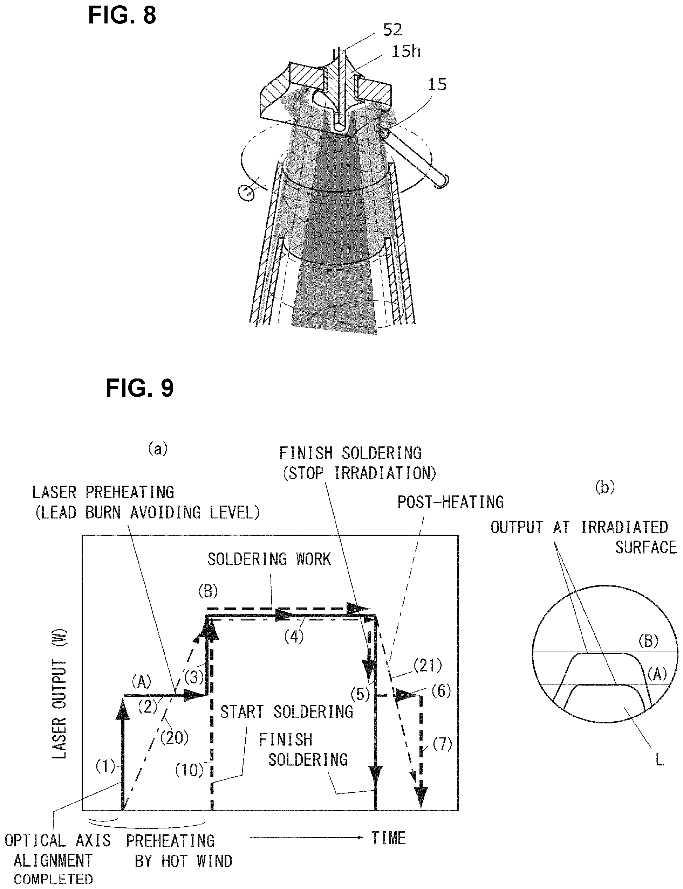

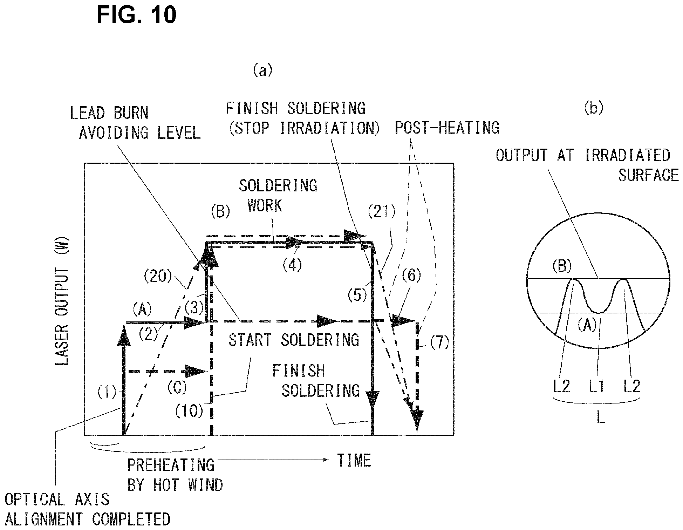

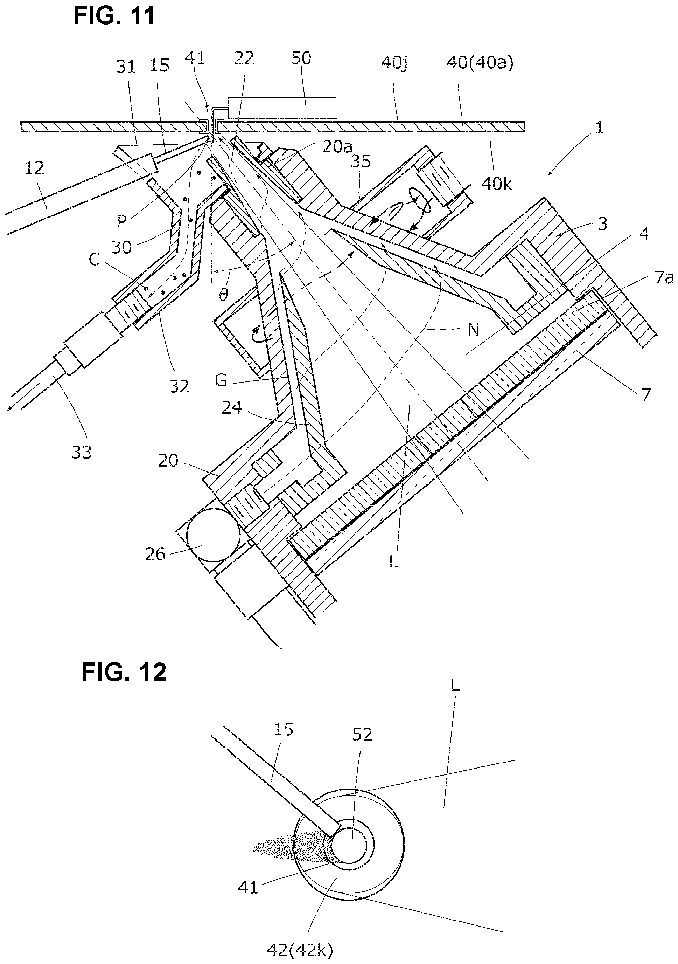

To achieve the above object, in the present invention, a laser beam L is emitted from the underside of a printed board 40. In accordance with this, measures are also taken for eliminating the relevant disadvantages. Two emission angles are used: a case where the laser beam L is emitted vertically toward a lower surface 40k of the printed board 40 (FIG. 1 to FIG. 8) and a case where the laser beam L is emitted obliquely (FIG. 11 and FIG. 12). In addition, as the laser beam L to be emitted, the following types are used: a laser beam having the same output level over an entire area of a transverse section at an irradiated surface as shown in FIG. 9(a) (hereinafter, this output level is referred to as uniform output level and this laser beam is referred to as uniform output laser beam), and a laser beam having an output level different between a center part and an outer peripheral part as shown in FIG. 10(a) (hereinafter, this output level is referred to as non-uniform output level and this laser beam is referred to as non-uniform output laser beam). Further, in accordance with this, various types of output procedures are adopted.

A laser soldering method (first aspect) of the present invention is a laser soldering method in which wire solder 15 fed toward a through hole 41 of a printed board 40 is melted by a laser beam L, and a lead 52, inserted through the through hole 41, of an electronic component 50 mounted on an upper surface 40j side of the printed board 40 is soldered to a land 42 provided to the through hole 41, wherein
the laser beam L is applied vertically or in an inclined state from an underside to the land 42 at a soldering point P,
a hot wind N is blown from an underside of the printed board 40 to the land 42 and the lead 52 protruding downward from the through hole 41, to preheat the land 42 and the lead 52,
at a time of starting the preheating or after the preheating is started, the laser beam L is applied to the land 42 and the lead 52 from the underside of the printed board 40, and meanwhile, the wire solder 15 is fed to a position contacting with either the land 42 or the lead 52 from the underside of the printed board 40,
subsequently, the fed wire solder 15 is melted by the laser beam L, and the land 42 and the lead 52 are connected by the melted solder 15m, and
thereafter, feeding of the wire solder 15 is stopped, and at a time of stopping the feeding of the wire solder 15 or after the feeding of the wire solder 15 is stopped, application of the laser beam L is stopped, to solidify the melted solder 15m.

According to claim 2, in the above soldering method, the uniform output laser beam L shown in FIG. 9(b) is used, and preheating (1), (2), (3) and a soldering step (4) in a first output procedure are adopted.

In the laser soldering method according to claim 1,
as the laser beam L, a laser beam L having an equal output level over an entire area of a transverse section at an irradiated surface is used,
the output level at a time of the preheating is set to a preheating level (A) not higher than a melting temperature of the wire solder 15, and
the output level at a time of the soldering is set to a melting level (B) not lower than the melting temperature of the wire solder 15.

According to claim 3, in the above soldering method, the uniform output laser beam L shown in FIG. 9(b) is used, and preheating (10) and the soldering step (4) in a second output procedure are adopted.

In the laser soldering method according to claim 1,
as the laser beam L, a laser beam L having an equal output level over an entire area of a transverse section at an irradiated surface is used,
at a time of the preheating, the preheating is performed using only the hot wind N, and
at a time of starting the soldering, the laser beam L is emitted and the output level thereof is set to a melting level (B) not lower than a melting temperature of the wire solder 15.

According to claim 4, in the above soldering method, the uniform output laser beam L shown in FIG. 9(b) is used, and preheating (20) and the soldering step (4) in a third output procedure are adopted.

In the laser soldering method according to claim 1,
as the laser beam L, a laser beam L having an equal output level over an entire area of a transverse section at an irradiated surface is used,
at a time of starting the preheating or at a stage during the preheating, the laser beam L is emitted, and the output level thereof is gradually increased from zero to a melting level (B) not lower than a melting temperature of the wire solder 15, and
the output level at a time of the soldering is set to the melting level (B) not lower than the melting temperature of the wire solder 15.

According to claim 5, in the above soldering method, the non-uniform output laser beam L shown in FIG. 10(b) is used, and the preheating (1), (2), (3) and the soldering step (4) in the first output procedure are adopted.

In the laser soldering method according to claim 1,
as the laser beam L, a laser beam L of which an output level in an entire area of a transverse section at an irradiated surface is higher at an outer peripheral part L2 thereof than at a center part L1 thereof is used,
setting is made such that the output level (A) at the center part L1 is lower than a melting temperature of the wire solder 15, the output level (B) at the outer peripheral part L2 is higher than the melting temperature of the wire solder 15, and the center part L1 is applied to an inner side of the through hole 41 of the land 42,
the output level at a time of the preheating is set to a preheating level (A) not higher than the melting temperature of the wire solder 15, and
the output level at a time of the soldering is set to a melting level (B) not lower than the melting temperature of the wire solder 15.

According to claim 6, in the above soldering method, the non-uniform output laser beam L shown in FIG. 10(b) is used, and the preheating (10) and the soldering step (4) in the second output procedure are adopted.

In the laser soldering method according to claim 1,
as the laser beam L, a laser beam L of which an output level in an entire area of a transverse section at an irradiated surface is higher at an outer peripheral part L2 thereof than at a center part L1 thereof is used,
setting is made such that the output level (A) at the center part L1 is lower than a melting temperature of the wire solder 15, the output level (B) at the outer peripheral part L2 is higher than the melting temperature of the wire solder 15, and the center part L1 is applied to an inner side of the through hole 41 of the land 42,
at a time of the preheating, the preheating is performed using only the hot wind N, and
at a time of starting the soldering, the laser beam L is emitted and the output level thereof is set to a melting level (B) not lower than the melting temperature of the wire solder 15.

According to claim 7, in the above soldering method, the non-uniform output laser beam L shown in FIG. 10(b) is used, and the preheating (20) and the soldering step (4) in the third output procedure are adopted.

In the laser soldering method according to claim 1,
as the laser beam L, a laser beam L of which an output level in a transverse section at an irradiated surface is higher at an outer peripheral part L2 thereof than at a center part L1 thereof is used,
setting is made such that the output level (A) at the center part L1 is lower than a melting temperature of the wire solder 15, the output level (B) at the outer peripheral part L2 is higher than the melting temperature of the wire solder 15, and the center part L1 is applied to an inner side of the through hole 41 of the land 42,
at a time of starting the preheating or at a stage during the preheating, the laser beam L is emitted, and the output level thereof is gradually increased from zero to a melting level (B) not lower than the melting temperature of the wire solder 15, and
the output level at a time of the soldering is set to the melting level (B) not lower than the melting temperature of the wire solder 15.

Claim 8 is directed to a device for performing the soldering method according to any of claims 1 to 7.

A laser soldering device 1 is for soldering a lead 52 of an electronic component 50 to a land 42 of a printed board 40 by a laser beam L and the laser soldering device 1 includes:
a support base 2 configured to support the printed board 40 in a state in which the electronic component 50 is mounted at an upper surface 40j of the printed board 40 and the lead 52 of the electronic component 50 protrudes downward from a through hole 41 of the printed board 40;
an emission head 3 provided under the printed board 40 so as to be vertical or inclined relative to the printed board 40, the emission head being configured to emit the laser beam L toward the land 42;
a wire solder feeding portion 11 configured to feed wire solder 15 to a position contacting with either the land 42 or the lead 52 at a time of soldering;
a hollow protection nozzle 20 provided at an emission port 4 of the emission head 3 and extending from the emission port 4 toward the printed board 40 present upward, the protection nozzle 20 having a pass hole 22 at a tip thereof facing the printed board 40; and
a heating gas supply pipe 26 provided to the protection nozzle 20 and configured to supply heating gas to the protection nozzle 20 so that a hot wind N is blown out from the pass hole 22 toward the printed board 40.

According to claim 9, an exhaust duct 30 is further provided for sucking the hot wind N blown out from the protection nozzle 20 together with spattering fine products C generated during soldering.

The laser soldering device 1 according to claim 8 further includes an exhaust duct 30 opened at an upper surface thereof opposed to a lower surface 40k of the printed board 40, at a position facing the pass hole 22 of the protection nozzle 20.

According to claim 10, regarding the laser beam L in claim 8,
as the laser beam L, either of the following laser beams L is used:
a laser beam L having an equal output level over an entire area of a transverse section at an irradiated surface; or
a laser beam L having a double ring structure having a center part L1 and an outer peripheral part L2 surrounding the center part L1 in a transverse section at an irradiated surface, the laser beam L being set such that an output level (A) at the center part L1 is not higher than a melting temperature of the wire solder and an output level (B) at the outer peripheral part L2 is not lower than the melting temperature of the wire solder.

According to claim 11, regarding the protection nozzle 20 in claim 8,
the protection nozzle 20 is formed such that a diameter thereof is reduced toward the pass hole 22, and
the protection nozzle 20 has therein a guide wall 24 for hot wind guide, the guide wall 24 being formed along an inner circumferential surface of the protection nozzle 20.

### Advantageous Effects of Invention

The present invention has the configuration as described above, and thus makes it possible to perform soldering from the underside of the printed board 40, which has been conventionally considered impossible. Further, in the present invention, the soldering point P is preheated by the hot wind N, and the laser beam L is applied vertically or in an inclined state from an obliquely lower side toward an obliquely upper side relative to the printed board 40, without laser beam L being moved. Thus, for an ultra-large-scale integrated printed board 40, the takt time for soldering work can be shortened as much as possible. Further, by appropriately configuring the output procedure or the laser beam L, lead burn of the electronic component 50 can also be avoided.

### Brief Description of Drawings

FIG. 1 is a sectional view showing an embodiment of a laser soldering device in vertical irradiation according to the present invention.
FIG. 2 is an enlarged sectional view of a protection nozzle part in FIG. 1.
FIG. 3 is an enlarged perspective sectional view of a part of FIG. 1 as seen from below.
FIG. 4 is a sectional view along line X-X in FIG. 2.
FIG. 5 is a perspective view at the start of soldering in the present invention.
FIG. 6 is a perspective view at the time of soldering in the present invention.
FIG. 7 is an enlarged sectional view in a soldered state in FIG. 6.
FIG. 8 is a perspective view at the time of post-heating after soldering is completed in the present invention.
FIG. 9 is an output control chart for a laser beam in a first method of the present invention.
FIG. 10 is an output control chart for a laser beam in a second method of the present invention.
FIG. 11 is a partial enlarged sectional view in inclined irradiation according to the present invention.
FIG. 12 is an enlarged view showing an irradiation state at a soldering point in FIG. 11 as seen from the lower surface side of a printed board.

### Description of Embodiments

Hereinafter, the present invention will be described with reference to the drawings. FIG. 1 shows a first embodiment (vertical irradiation) of a soldering device 1, and FIG. 11 shows a second embodiment (inclined irradiation) thereof. In the second embodiment, difference from the first embodiment will be mainly described, and for the same matter, description in the first embodiment is applied to description in the second embodiment and the same matter will not be described repeatedly.

The soldering device 1 includes a semiconductor laser or a laser oscillator (not shown) that outputs a laser beam L; a support base 2 on which a printed board 40 is set; an emission head 3 that is provided under the printed board 40 and applies a laser beam L outputted from the semiconductor laser or the like to a soldering point (in the present invention, a part on the lower surface side of a land 42 of the printed board 40, this part is referred to as land-lower-surface part 42k) provided on a lower surface 40k of the printed board 40; a laser controller (not shown) for controlling the semiconductor laser or the like; a wire solder feeding portion 11 for feeding wire solder 15 to the soldering point; a monitor 10 that displays a solder state; and a control device (not shown) that automatically controls the entire soldering device 1 in accordance with a set program.

The printed board 40 is a board on which a large number of and various kinds of electronic components 50 are to be mounted. The printed board 40 is not limited to a single-layer board but may be a multilayer board. Here, a case where the printed board 40 is a single-layer board will be described as a representative example.

A board body (insulating substrate) 40a of the printed board 40 has multiple through holes penetrating from an upper surface 40j thereof to the lower surface 40k. On the inner circumferential surface of the through hole and the peripheral edges of openings of the through hole on the front and back sides of the board body 40a, there is a copper plating layer left as a result of etching treatment. This copper plating layer part is the land 42, and a hole penetrating through the land 42 is the through hole 41.

The ring-shaped copper plating layers at the opening peripheral edges of the land 42 are defined as land-upper-surface part 42j and land-lower-surface part 42k, and the copper plating layer on the inner circumferential surface of the through hole, connecting the land upper and lower surface parts 42j and 42k, is defined as conduction part 43.

A large number of and various kinds of electronic components 50 are mounted at the upper surface 40j of the printed board 40, and a lead 52 of each electronic component 50 is inserted into the through hole 41. The inserted lead 52 passes through the through hole 41 and slightly protrudes from the lower surface 40k. The inserted lead 52 is to be soldered over the entire land 42 of the printed board 40 by a method described later. It is noted that the leads 52 may have various sectional shapes such as a circular shape or a quadrangular shape in accordance with the various kinds of electronic components 50.

In the present invention, on the lower surface 40k side of the printed board 40 where the inserted lead 52 protrudes, the protruding lead 52 and the land-lower-surface part 42k are irradiated with the laser beam L, whereby the wire solder 15 fed to the irradiated part is melted and the lead 52 and the land 42 are soldered (FIG. 8).

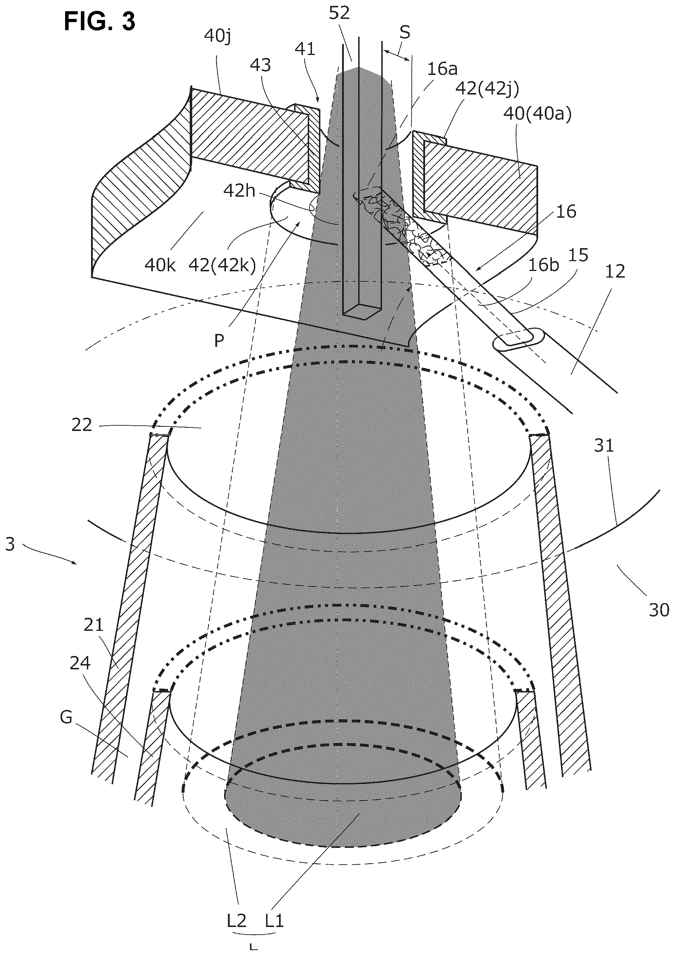

The relationship between the copper plating layer (conduction part 43) that is the inner circumferential part of the land 42, and the lead 52 of the electronic component 50, is as follows. The diameter of the lead 52 is slightly smaller than the inner diameter of the conduction part 43, and a gap S between the conduction part 43 and the lead 52 is slight (e.g., around 0.1 mm) and is a gap that allows melted solder 15m to penetrate by capillary action as described later (FIG. 3).

The emission head 3 of the soldering device 1 is placed under the printed board 40 placed on the support base 2 of the soldering device 1. The land-lower-surface part 42k at the soldering point on the lower surface 40k of the printed board 40 is exposed downward from an opening part of the support base 2.

As shown in FIG. 1, the emission head 3 may be placed vertically to the printed board 40 so that the emission port 4 of the emission head 3 faces the lower surface 40k of the printed board 40 (first embodiment), and as shown in FIG. 11, the emission head 3 may be placed so as to be inclined relative to the printed board 40 (second embodiment).

The outer shape of the emission head 3 is substantially a cylindrical shape or a polygonal tube shape, and a laser introducing tube portion 5 protrudes orthogonally from the side surface of the emission head 3. An optical fiber 8 leading to the semiconductor laser or the like is connected to the laser introducing tube portion 5, so that the laser beam L outputted from the semiconductor laser or the like passes through the optical fiber 8 and is introduced into the emission head 3. Inside the emission head 3, a semi-transparent mirror 6a for changing the direction of the introduced laser beam L and optical components 6b such as optical lenses for focusing the laser beam L to a predetermined diameter on the land-lower-surface part 42k at the soldering point, are mounted at certain positions on an optical path to the emission port 4.

As described above, the emission port 4 is provided at the upper end of the emission head 3 and faces the lower surface 40k of the printed board 40. The laser beam L entering the emission head 3 passes through an internal optical system 6 and then is emitted from the emission port 4 toward the land-lower-surface part 42k at the soldering point P. At the emission port 4, protection glass 7 transparent over the entire area, and center-part-output limiting glass 7a provided if necessary as described later, are mounted.

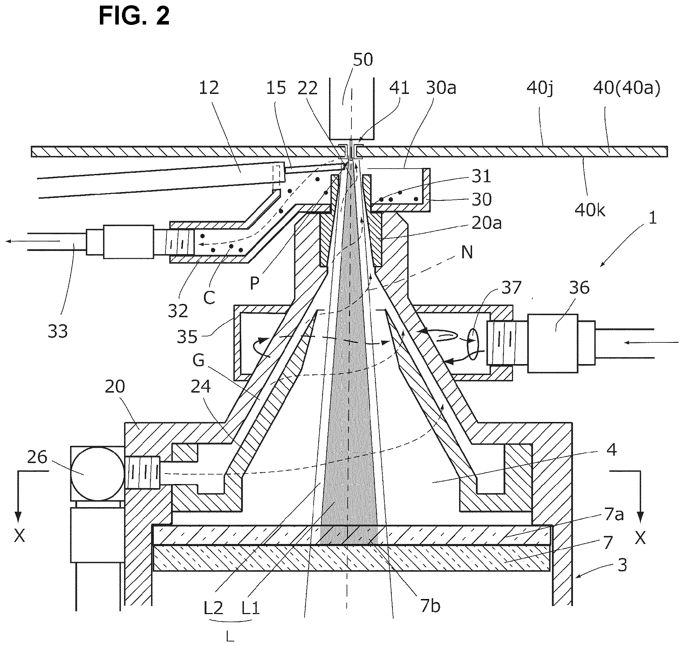

As the laser beam L emitted from the emission port 4 toward the land-lower-surface part 42k at the soldering point P, two types are used. The first type has the same output level over an entire area of the transverse section at the land-lower-surface part 42k, which is the irradiation surface (FIG. 1, FIG. 9(b)), and the second type has a double ring structure having a center part L1 and an outer peripheral part L2 formed concentrically therearound and surrounding the center part L1 (FIG. 2, FIG. 10(b)). In this case, the second type is set such that the outer peripheral part L2 has a higher output level than the center part L1.

In FIG. 2, the laser beam L having the double ring structure of the second type is shown, and the center part L1 is shown as a shaded part.

In FIG. 10, a uniform output laser beam L set in an inclined state is shown. However, without limitation thereto, a non-uniform output laser beam is also used (not shown).

In a case where the laser beam L has a uniform output level as in the first type, a setting for lowering the output level of the center part L1 of the laser beam L is not made in the optical system 6, and therefore the laser beam L entering the emission head 3 passes as it is through the optical system 6 and the protection glass 7 of the emission head 3, thus having the same output level over the entire area of the transverse section at the irradiation surface as described above. The output level in this case is schematically shown in FIG. 9(b). The irradiation range of the uniform output laser beam L is set to be the land-lower-surface part 42k in both of a case of vertical irradiation and a case of inclined irradiation, as described later.

In a case where the laser beam L having a high uniform output level (output level (B) not lower than a wire solder melting temperature) is set vertically and is continuously applied to a protruding end of the lead 52 during a preheating period, the protruding end is overheated and thus the color thereof might be changed by so-called lead burn. Therefore, the output level of the laser beam L is controlled so as not to cause "lead burn", as described later.

It is noted that, in a case where the laser beam L having the high uniform output level is set in an inclined state and the laser beam L is applied obliquely to the soldering point P, as shown in FIG. 12, the irradiated surface expands in an elliptic shape and thus the output level is slightly lowered as compared to the vertical case. Also in this case, output control is performed so as not to cause "lead burn", as necessary.

On the other hand, in a case where the laser beam L is set as the non-uniform output laser beam L of the second type, a member (not shown) for limiting the output level of the center part L1 of the laser beam L is provided at any position in the optical system 6 of the emission head 3, or as shown in FIG. 2, the center-part-output limiting glass 7a having an output limiting area 7b for limiting the output level of the center part of the laser beam L is provided along the upper surface of the protection glass 7. In this case, if the output level of the outer peripheral part L2 is 100, the output level of the center part L1 is limited to a range of 40 to 60. Change of the output level is performed by replacing the center-part-output limiting glass 7a with other ones having various limitation values.

The diameter of the center part L1 of the non-uniform output laser beam L is, at maximum, equal to the inner diameter of the through hole 41. Thus, the output level of the center part L1 applied to the protruding end of the lead 52 inserted through the through hole 41 becomes considerably lower than the surrounding outer peripheral part L2, so that "lead burn" does not occur even if the laser beam of the center part L1 having a low output level is continuously applied during a preheating step.

Also for the non-uniform output laser beam L, there are a case where the laser beam L is set vertically and a case where the laser beam L is set in an inclined state.

In the case where the non-uniform output laser beam L is set vertically, the outer peripheral part L2 thereof is a ring-shaped area obtained by subtracting, from the irradiation area of the laser beam L covering the land-lower-surface part 42k at the soldering point P, the center part L1 located at a center part of the irradiation area. If the land-lower-surface part 42k of the printed board 40 has a circular shape, the laser beam L is applied over the entire land-lower-surface part 42k, and the maximum diameter position of the laser beam L is at the outer edge of the land-lower-surface part 42k. (The shape of the land-lower-surface part 42k of the printed board 40 is not limited to a circular shape but may be various shapes. For example, in a case of an oblong shape, the range of the laser beam L corresponds to the short-side width of the oblong shape so that the laser beam L is not applied to the board body 40a, which is an insulating material.)

In a case where the non-uniform output laser beam L is set in an inclined state, as shown in FIG. 12, the irradiated surface has an elliptic shape, and therefore the laser beam L is applied in such a range that the major-axis side thereof does not protrude out of the land-lower-surface part 42k.

Above the protection glass 7 (or center-part-output limiting glass 7a), a protection nozzle 20 is mounted to the emission port 4 of the emission head 3. The protection nozzle 20 has a hollow conical shape extending upward from the emission port 4, and a tubular nozzle port 21 is fitted to the tip part of the protection nozzle 20. The nozzle port 21 is made of a heat resistant material, e.g., ceramic. The nozzle port 21 has a pass hole 22 through which the laser beam L narrowed to be thin passes. The diameter of the pass hole 22 is slightly larger than the diameter of the laser beam L passing therethrough.

A heating gas supply pipe 26 is connected to a base part of the protection nozzle 20 near the emission port 4 of the emission head 3, and high-temperature gas is constantly supplied to the inside. The high-temperature gas may be normal air or an inert gas such as nitrogen gas. The melting point of the wire solder 15 varies depending on the composition thereof, and in a case of leadfree solder, is approximately 220°C. The temperature of the high-temperature gas supplied to the protection nozzle 20 is such a temperature that can preheat the through hole 41 and the surrounding area, and the wire solder 15 fed thereto (e.g., 110°C to 150°C) and that does not exceed, at maximum, a temperature shortly below the melting point of the wire solder 15. Then, the high-temperature gas is blown out upward from the pass hole 22, as a hot wind N. The inside of the protection nozzle 20 is constantly kept at a positive pressure by the high-temperature gas being supplied. Therefore, a foreign material (fine product) C does not enter the inside of the protection nozzle 20 from the pass hole 22.

The protection nozzle 20 may be a mere conical hollow tube body (not shown). In FIG. 2 and FIG. 3, an example in which the protection nozzle 20 is provided with a conical guide wall 24 along the inner circumferential surface thereof, is shown.

The guide wall 24 forms a guide flow path G that guides flow of the hot wind N, between the inner circumferential surface of the protection nozzle 20 and the guide wall 24. If the gap between the inner circumferential surface and the guide wall 24 is gradually narrowed toward the pass hole 22, the flow speed of the hot wind N flowing through the guide flow path G can be increased. It is noted that the guide wall 24 covers the upper surface of the protection glass 7 (or center-part-output limiting glass 7a) and thus prevents the high-temperature gas blown into the protection nozzle 20 from contacting with the protection glass (or center-part-output limiting glass 7a).

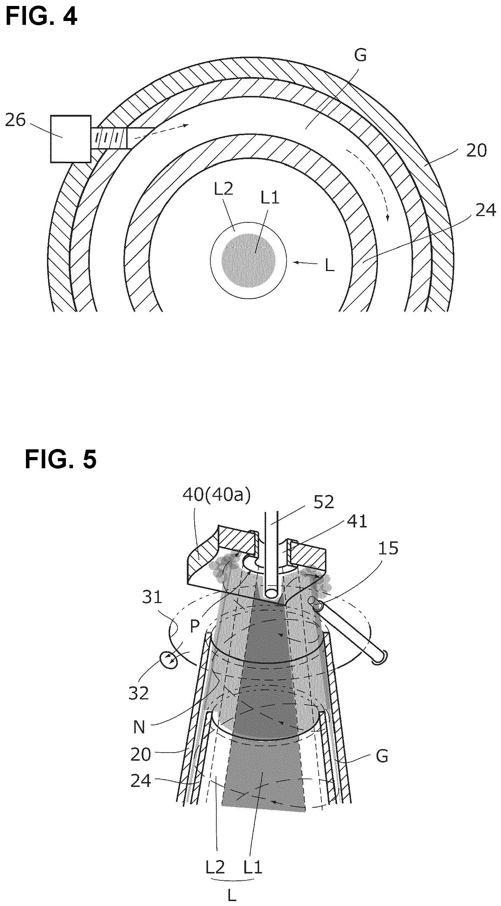

The heating gas supply pipe 26 may be connected perpendicularly to the base part of the protection nozzle 20. Alternatively, as shown in FIG. 4, the heating gas supply pipe 26 may be connected in the tangent direction of the inner circumferential surface of the protection nozzle 20 so that the blown high-temperature gas forms a helical flow along the inner circumferential surface (or guide flow path G) inside the protection nozzle 20 and is blown out as a thin helical-flow hot wind N from the pass hole 22. By forming the hot wind N as a helical flow, the directionality of the blow-out direction is enhanced, and thus the lead 52 and the land 42 located near the pass hole 22 can be intensively preheated.

Here, preheating by the hot wind N from the underside of the printed board 40 is disclosed. However, in addition thereto, preheating by a hot wind N from the upper side of the printed board 40 may be further performed.

In the present embodiment, an exhaust duct 30 is provided so as to surround the circumference of the pass hole 22 of the protection nozzle 20. The exhaust duct 30 is provided as necessary and is not essential. Here, an example in which the exhaust duct 30 is provided is shown.

The exhaust duct 30 is a dish-like member and has an opening 31 at the center thereof. An upper end part (nozzle port 21) of the protection nozzle 20 is inserted into the opening 31. An upper edge 30a of the exhaust duct 30 and an upper end of the nozzle port 21 of the protection nozzle 20 are located below the lower surface 40k of the printed board 40 located upward, and are provided with a gap from the lower surface 40k.

This gap is formed to have a width greater than the protruding interference of the lead 52 from the lower surface 40k of the printed board 40. Thus, even if the emission head 3 moves together with the exhaust duct 30 relative to the printed board 40 when soldering is finished, the upper edge 30a of the exhaust duct 30 and the upper end of the nozzle port 21 do not contact with the protruding end of the lead 52 having been soldered.

An exhaust tube portion 32 is provided to the side wall of the exhaust duct 30, and an exhaust pipe 33 is connected to the exhaust tube portion 32. The exhaust pipe 33 constantly sucks and discharges air in the exhaust duct 30.

The hot wind N blown out from the pass hole 22 of the nozzle port 21 of the protection nozzle 20 hits the lower surface 40k of the printed board 40 (at the time of soldering, the lead 52, the through hole 41, and the surrounding area), to preheat the hit part, and then flows into the exhaust duct 30. Then, most or the entirety of the hot wind N flows into the exhaust pipe 33.

Thus, air in the exhaust duct 30 and most or all of fine products C such as solder balls and fume generated during soldering and flying into the air are discharged through the exhaust pipe 33.

A ring-shaped cooling pipe 35 is provided around the outer circumference of a trunk portion of the protection nozzle 20, and a cooling water supply pipe 36 and a cooling water discharge pipe 37 are attached to the cooling pipe 35. Cooling water is supplied from the cooling water supply pipe 36, circulates through the cooling pipe 35, and returns to the cooling water discharge pipe 37, so as to be discharged therethrough. Thus, the protection nozzle 20 is cooled by the cooling water.

The wire solder feeding portion 11 is for feeding the wire solder 15 wound around, for example, a pulley (not shown), toward the land-lower-surface part 42k of the land 42 at the soldering point, on a required amount basis as necessary. The wire solder feeding portion 11 has a guide nozzle 12 extending to a position close to the land-lower-surface part 42k at the soldering point. In soldering work, the wire solder feeding portion 11 receives a control command such as a feeding timing and a feeding amount of the wire solder 15 from the control device, and sends the wire solder 15 through the guide nozzle 12 in accordance with the control command. The sent wire solder 15 is fed to a position contacting with the lead 52 or the land-lower-surface part 42k at the soldering point, or a position contacting with both of them. At this time, as described later, the tip of the fed wire solder 15 is exposed to only the hot wind N or to the hot wind N and the laser beam L, so as to be preheated, but since the heating temperature of the hot wind N and the output level of the laser beam L are low, the wire solder 15 is not melted at this point of time.

In general, the sectional shape of the wire solder 15 is a circular shape. However, as shown in FIG. 1 and FIG. 3, the wire solder 15 may be compressed to be flattened by a pair of upper and lower press rollers 13 before inserted into the guide nozzle 12 so that flat parts 16a, 16b are formed on the front and back sides of the wire solder 15. In this case, a guide hole of the guide nozzle 12 also has a flattened rectangular shape corresponding to the wire solder 15, and the flattened wire solder 15 is fed such that one flat part 16a thereof is along the lower surface 40k of the printed board 40. Thus, the laser beam L is applied to the flat part 16b on the opposite side, so that the laser beam L is less scattered and is readily absorbed by the flattened wire solder 15.

At the time of soldering, or preheating and soldering, an oscillation control command is issued from a laser controller. In response thereto, the semiconductor laser or the like emits the laser beam L with a predetermined output and an irradiation time, and the emission head 3 emits the laser beam L vertically or obliquely upward from the underside toward the land-lower-surface part 42k at the soldering point. Then, the wire solder 15 is fed thereto.

In either case, in principle, feeding of the wire solder 15 is completed before the (uniform/non-uniform output) laser beam L having the output level (B) is emitted.

Thus, at the time of soldering, the wire solder 15 is heated and melted by the laser beam L and soldering is performed.

At a lower end of the emission head 3, a CCD camera 9 is attached such that the optical axis thereof is coaxial with the laser beam L, and the soldering point can be imaged through the emission port 4 by the CCD camera 9. The image of the soldering point taken by the CCD camera 9 is displayed on the monitor 10 via the control device.

Before soldering, it is possible to use the CCD camera 9 for performing aiming adjustment of the laser beam L with respect to the land-lower-surface part 42k at the soldering point while viewing the image displayed on the monitor 10, or during soldering work, it is possible to observe the state of soldering work at the soldering point by the CCD camera 9.

Next, operation of the soldering device 1 according to the present invention will be described. Embodiments of the laser soldering method according to the present invention include the first embodiment (FIG. 1 to FIG. 8: vertical arrangement) and the second embodiment (FIG. 11: inclined arrangement).

The first embodiment is a case where the emission head 3 is placed vertically to the lower surface 40k of the printed board 40, and the second embodiment is a case where the emission head 3 is placed so as to be inclined by an inclination angle θ relative to a line vertical to the lower surface 40k of the printed board 40. The inclination angle θ is 50° ± 10°.

In addition, regarding the laser beam L, there are two cases of emission at the uniform output level and emission at the non-uniform output level as described above.

Regarding a soldering procedure, as shown in FIG. 9(a) and FIG. 10(a), there are a case of changing the laser output in stages, i.e., a first output procedure ((1), (2), (3), (4), (5), (6), (7)), a case of changing the laser output continuously, i.e., a second output procedure ((20), (4), (21)), and a case of performing output in a rectangular manner, i.e., a third output procedure ((10), (4), (5)).

In the chart of the first output procedure, the output is set at two stages of a level (A) and a level (B), but without limitation thereto, may be set in any multiple stages. In this case, the level (A) is an output level that does not cause "lead burn" (such an output that the temperature at the irradiated part is increased to about 110°C to 150°C), and the level (B) is an output level that enables "soldering" (not lower than the solder melting temperature).

The first to third output procedures are determined on the basis of the condition of a soldering target, and the switching timing therefor is determined by software inputted to a controller or determined through detection for a measurement temperature at the soldering point by a radiation thermometer (not shown).

Regarding preheating for the soldering point P, there are two cases where preheating is performed by only the hot wind N without the laser beam L and where preheating is performed through cooperation using the hot wind N and the laser beam L.

### Soldering work in first embodiment (vertical)

Hereinafter, soldering work in the first embodiment (vertical) using the uniform output laser beam L or the non-uniform output laser beam L will be described (FIG. 1, FIG. 2 to FIG. 8, FIG. 9, FIG. 10).

The optical axis of the emission head 3 is aligned with the center of the through hole 41 as the soldering target of the printed board 40 placed on the support base 2 of the soldering device 1. The emission head 3 is provided under the printed board 40 vertically to the printed board 40. The above optical axis alignment is automatically performed through image processing or may be manually adjusted via the monitor 10.

Before completion of the optical axis alignment, the hot wind N blown out from the pass hole 22 is blown around the land-lower-surface part 42k at the soldering point P, thereby heating this part. At this time, the laser beam L is not being emitted.

### First output procedure (FIG. 9(a), FIG. 10(a): (1) to (7))

Preheating step (cooperative preheating using hot wind N and laser beam L)

When the optical axis alignment is finished as described above, the pass hole 22 is located directly under the land-lower-surface part 42k at the soldering point P. At this time, the hot wind N blown out from the pass hole 22 has been preheating the through hole 41 and the surrounding area, and the lead 51 inserting through the through hole 41. Then, at the time of completion of the optical axis alignment or after completion of the optical axis alignment, the uniform or non-uniform output laser beam L is emitted toward the lead 52 and the land-lower-surface part 42k at the soldering point (see (1) in FIG. 9(a) and FIG. 10(a)).

In the case of the uniform output laser beam L, if the output level thereof is high, the lead 52 is overheated, thus causing a "lead burn" phenomenon in which the color of the irradiated part is changed. Therefore, at this time, the output is limited to such a degree (indicated by level (A)) that does not cause a "lead burn" phenomenon. At this output level (A), the preheating temperature by the hot wind N and the laser output is a temperature (e.g., 110 to 150°C) lower than the melting point of the used wire solder 15.

In the case of the non-uniform output laser beam L, the output level of the outer peripheral part L2 is set at (A) so that the wire solder 15 fed to the soldering point P is not melted. Since the output level of the center part L1 is (B) and thus is lower than the output level of the outer peripheral part L2, it suffices that the output level of the outer peripheral part L2 is managed.

In a case where the hot wind N is not a helical flow but is blown out vertically toward the through hole 41 from the pass hole 22, as described above, the hot wind N preheats the surrounding area around the land-lower-surface part 42k, the inner circumferential surface of the through hole 41, and the lead 52 inserted through the through hole 41, and further, the hot wind N passing through the through hole 41 and coming around to the upper surface 40j side of the printed board 40 preheats the land-upper-surface part 42j and the surrounding area. This also applies to the soldering procedure described later.

In a case where the hot wind N is blown out toward the through hole 41 while swirling helically, the blowing-out directionality is enhanced as compared to the case of merely blowing out as described above and the hot wind N is blown into the through hole 41, whereby the lead 52 present at the center of the through hole 41 is mainly preheated. A major part of the hot wind N hitting the through hole 41 including the lead 52 directly flows to the surrounding area, to preheat the land-lower-surface part 42k. The rest of the hot wind N passing through the through hole 41 preheats the land-upper-surface part 42j and the surrounding area. This also applies to the soldering procedure described later. A period for the preheating is determined by time setting from the finish time of optical axis alignment or measurement for the temperature at the preheated part using a radiation thermometer.

### Soldering step

After the preheating has been performed as described above, the operation is switched to a soldering step along with finish of the preheating step. Thus, in the case of the uniform output laser beam L, the output thereof is switched to the level (B). In the case of the non-uniform output laser beam L, the output for the outer peripheral part L2 is switched to the level (B).

Feeding of the wire solder 15 is performed before the output of the laser beam L (or outer peripheral part L2) is switched to the level (B).

When the wire solder 15 contacts with the lead 52 (or land-lower-surface part 42k), the laser beam L (or outer peripheral part L2) at the level (B) is outputted thereto and the wire solder 15 is rapidly melted from the irradiated part including the contact part. When the wire solder 15 changes from a solid phase to a liquid phase, latent heat is needed and therefore the temperature of the melted solder 15m is slightly lowered, but the melted solder 15m is kept in a liquid phase by heat from the laser beam L. The wire solder 15 is continuously fed to the soldering point P until just before soldering is finished, and thus is continuously melted.

During the soldering step, the amount of the melted solder 15m increases through feeding of the wire solder 15 as described above. Thus, the melted solder 15m spreads over the lead 52 and the land-lower-surface part 42k, to connect both parts, and meanwhile, passes through the gap S between both preheated parts by a "capillary action", to rise toward the upper surface 40j of the printed board 40, so that the melted solder 15m spreads over the land-upper-surface part 42j of the printed board 40 and the lead 52, and fills the gap S therebetween.

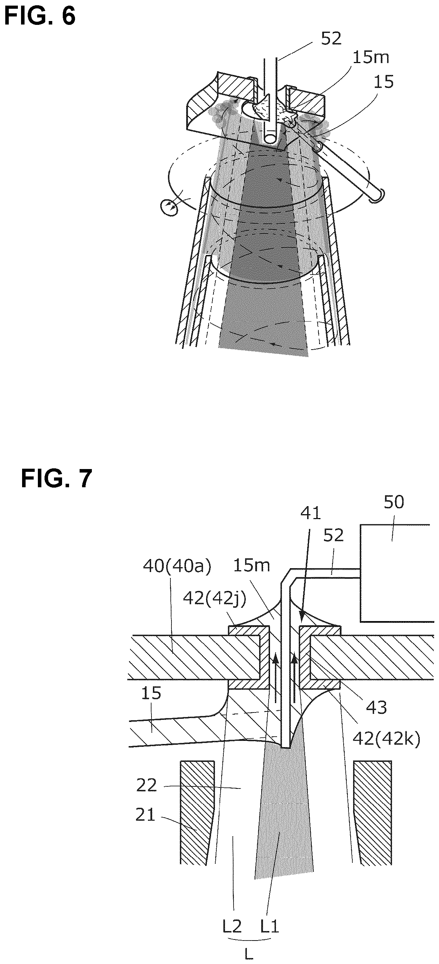

As described above, since the entire through hole 41 and the lead 52 are preheated, the melted solder 15m exhibits the above "capillary action" while being kept in a liquid phase without being solidified (FIG. 6).

In a case where the sectional shape of the wire solder 15 is a circular shape, when the laser beam L is applied to the outer surface thereof, the laser beam L is scattered around and thus the energy absorption efficiency is deteriorated. However, in a case where the wire solder 15 is compressed to be flattened by the press rollers 13 before feeding of the wire solder, when the laser beam L is applied vertically to the one flat part 16b, the scattering amount therearound is reduced, and the wire solder 15 is melted faster than the wire solder 15 having a circular shape.

In the above soldering step, since soldering is performed from the underside of the printed board 40, fume generated when the wire solder 15 is melted or fine products C such as fine solder balls popping out when the wire solder 15 is melted, might fly to the surrounding area around the soldering part. These are blown away by the hot wind N blowing out from the pass hole 22 of the protection nozzle 20, and thus do not enter the inside of the protection nozzle 20. Therefore, the protection glass 7 of the emission head 3 is not contaminated even when soldering is performed from the underside of the printed board 40. (As long as the hot wind N is appropriate, the fine products C are blown away to the surrounding area and do not adhere to the protection glass 7 of the emission head 3. Therefore, in this case, the protection nozzle 20 may not be provided.)

The fume and the other fine products C blown away by the hot wind N are received by the exhaust duct 30 provided so as to surround the periphery of the protection nozzle 20 and kept at a negative pressure therein, and then are discharged through the exhaust pipe 33 to the outside. The inside of the exhaust duct 30 is constantly kept at a negative pressure by discharge through the exhaust pipe 33 as described above, and the outer air flows inward from a gap between the printed board 40 and the upper edge of the exhaust duct 30. Therefore, leakage of the fine products C to the outside of the exhaust duct 30 during the soldering work is significantly suppressed. Thus, the surrounding environment is prevented from being contaminated by soldering from the underside of the printed board 40.

In soldering by the laser beam L from the upper side of the printed board 40 as in the conventional case, the fine products C soaring upward might drop onto the printed board 40 over time, whereas this never occurs in soldering from the underside as in the present invention.

In the above soldering step, the uniform output laser beam L having the high output level (B) is continuously applied to the tip of the lead 51, but heat provided to the lead 51 by the laser beam L is absorbed by the wire solder 15m being melted continuously. Thus, temperature increase is suppressed and "lead burn" does not occur.

On the other hand, in the case of the non-uniform output laser beam L, the output level of the center part L1 at this time is such a low level (A) that the wire solder 15 is not melted. Therefore, "lead burn" does not occur even when the laser beam L is continuously applied to the tip of the lead 51 as described above.

### Post-heating step

When soldering between the through hole 41 and the lead 52 is finished, the laser beam L is stopped in this state (procedure (5)). Then, the emission head 3 is moved to the next soldering point P, and the preheating and the soldering work described above are performed at the movement destination.

In the case where the laser beam L is immediately stopped after soldering is finished as described above (procedure (5)), during movement to the next soldering point P, solder 15h being solidified is rapidly solidified as a result of stoppage of the laser beam L even though receiving heat from the hot wind N. Thus, there is a risk that strain (or separation) due to rapid cooling occurs at the soldered part. Therefore, it is desirable that, from the time when soldering is finished, the output level of the laser beam L is lowered in stages (procedures (6), (7)). In the case of limiting the output in stages, the output is lowered in two stages in the drawings, but may be lowered in any multiple stages.

As a result, ideally, solidified solder 15h having a conical shape as shown in FIG. 8 is formed on the front and back sides of the printed board 40.

### Second output procedure (shown by thin dashed-dotted lines in FIG. 9(a) and FIG. 10(a): (20), (4), (21))

### Preheating step: using hot wind and laser beam in combination

In a preheating step, heating by the hot wind N and heating by the uniform output or non-uniform output laser beam L are performed at the soldering point P. After optical axis alignment is completed, the output level of the laser beam L is continuously increased until start of soldering. At the time when soldering is started, the output level of the uniform output laser beam L or the outer peripheral part L2 of the non-uniform output laser beam L is (B). For the matters other than the above, the description of the first output procedure is applied.

### Soldering step

As in the first output procedure, the wire solder 15 is fed and soldering is performed. Therefore, the first output procedure is applied.

### Post-heating step

At the same as the soldering is finished, the output of the laser beam L is gradually reduced. Thus, the melted solder 15m can be prevented from being rapidly cooled, and strain in the solidified solder 15h is relaxed. For the matters other than the above, the description of the first output procedure is applied.

### Third output procedure (FIG. 9(a), FIG. 10(a): broken-line arrows (10), (4), (5)/(6), (7))

### Preheating step: preheating by hot wind alone

In a preheating step, the laser beam L is not emitted and heating by the hot wind N alone is performed at the soldering point P. In this case, after the tip alignment is finished, when a specified preheating period has elapsed (or when the temperature at the soldering point P measured by the radiation thermometer has reached a soldering start temperature), soldering is started. Soldering step

As in the first output procedure, the wire solder 15 is fed and soldering is performed. Therefore, the first output procedure is applied.

### Post-heating step

As in the first output procedure, the laser beam L is stopped at the same time as soldering is finished. Alternatively, the output level is lowered in stages. This step is also the same as that in the first output procedure, and therefore the first output procedure is applied. (As a matter of course, gradual cooling in the post-heating step in the second output procedure may be used.) For the matters other than the above, the description of the first output procedure is applied.

Next, soldering work in the second embodiment will be described. In the second embodiment, as described above, the emission head 3 is provided so as to be inclined relative to the vertical line of the printed board 40. Therefore, in this case, the optical axis of the emission head 3 is aligned with the protrusion base of the lead 51 protruding from the through hole 41. In the second embodiment, establishing this state is defined as "optical axis alignment".

Preferably, the wire solder 15 is fed from such a direction as not to be hidden by the lead 52 and as not to interfere with the tip of the protection nozzle 20. The hidden part is shown as a shaded part (FIG. 12). In FIG. 12, the wire solder 15 is fed at an angle of 140° with respect to the optical axis of the laser beam L. As a matter of course, the angle is not limited thereto.

When the laser beam L is incident on the soldering point P so as to be inclined relative to the vertical line of the printed board 40, the irradiated surface forms an elliptic shape (FIG. 12). In the case of the uniform output laser beam L, to be exact, as shown in FIG. 9(b), the output level on the irradiated surface is not entirely uniform, but is high at the center part and slightly lower at the outer edge part than at the center part, for an optical reason.

When the soldering point P is irradiated in a state in which the optical axis is aligned with the protruding base of the lead 51 as described above, the wire solder 15 is rapidly melted to flow to the lead 52 and the land-lower-surface part 42k, thus covering these parts.

During a short period after the start of emission of the laser beam L and before the above covering, the protruding part of the lead 52 is irradiated with the laser beam L having the high level (B), but as described above, even in the case of the uniform output laser beam L, the outer peripheral part thereof has a lower output level, and therefore "lead burn" does not occur as long as the protruding part is exposed only for such a short period before the covering.

On the other hand, in the case of the non-uniform output laser beam L, the output level of the center part L1 is lower than the output level of the outer peripheral part L2, as described above. Since the protruding part of the lead 52 is exposed to the center part L1 having the lower output level, as a matter of course, "lead burn" does not occur. The wire solder 15 is melted by being exposed to the outer peripheral part L2 having the higher output level.

The other matters are the same as in the first embodiment and therefore the description in the first embodiment is applied.

### Reference Signs List

- 1: soldering device
- 2: support base
- 3: emission head
- 4: emission port
- 5: laser introducing tube portion
- 6: optical system
- 6a: semi-transparent mirror
- 6b: optical component
- 7: protection glass
- 7a: center-part-output limiting glass
- 8: optical fiber
- 9: CCD camera
- 10: monitor
- 11: wire solder feeding portion
- 12: guide nozzle
- 13: press roller
- 15: wire solder
- 15h: solidified solder
- 15m: melted solder
- 16a,: 16b flat part
- 20: protection nozzle
- 21: nozzle port
- 22: pass hole
- 24: guide wall
- 26: heating gas supply pipe
- 30: exhaust duct
- 30a: upper edge
- 31: opening
- 32: exhaust tube portion
- 33: exhaust pipe
- 40: printed board
- 40a: board body
- 40j: upper surface
- 40k: lower surface
- 41: through hole
- 42: land
- 42j: land-upper-surface part
- 42k: land-lower-surface part
- 42n: inner edge
- 43: conduction part
- 50: electronic component
- 51: lead
- C: fine product
- G: guide flow path
- L: laser beam
- L1: center part
- L2: outer peripheral part
- N: hot wind
- S: gap

## Claims

1. A laser soldering method in which wire solder fed toward a through hole of a printed board is melted by a laser beam, and a lead, inserted through the through hole, of an electronic component mounted on an upper surface side of the printed board is soldered to a land provided to the through hole, wherein
the laser beam is applied vertically or in an inclined state from an underside to the land at a soldering point,
a hot wind is blown from an underside of the printed board to the land and the lead protruding downward from the through hole, to preheat the land and the lead,
at a time of starting the preheating or after the preheating is started, the laser beam is applied to the land and the lead from the underside of the printed board, and meanwhile, the wire solder is fed to a position contacting with either the land or the lead from the underside of the printed board,
subsequently, the fed wire solder is melted by the laser beam, and the land and the lead are connected by the melted solder, and
thereafter, feeding of the wire solder is stopped, and at a time of stopping the feeding of the wire solder or after the feeding of the wire solder is stopped, application of the laser beam is stopped, to solidify the melted solder.

2. The laser soldering method according to claim 1, wherein
as the laser beam, a laser beam having an equal output level over an entire area of a transverse section at an irradiated surface is used,
the output level at a time of the preheating is set to a preheating level not higher than a melting temperature of the wire solder, and
the output level at a time of the soldering is set to a melting level not lower than the melting temperature of the wire solder.

3. The laser soldering method according to claim 1, wherein
as the laser beam, a laser beam having an equal output level over an entire area of a transverse section at an irradiated surface is used,
at a time of the preheating, the preheating is performed using only the hot wind, and
at a time of starting the soldering, the laser beam is emitted and the output level thereof is set to a melting level not lower than a melting temperature of the wire solder.

4. The laser soldering method according to claim 1, wherein
as the laser beam, a laser beam having an equal output level over an entire area of a transverse section at an irradiated surface is used,
at a time of starting the preheating or at a stage during the preheating, the laser beam is emitted, and the output level thereof is gradually increased from zero to a melting level not lower than a melting temperature of the wire solder, and
the output level at a time of the soldering is set to the melting level not lower than the melting temperature of the wire solder.

5. The laser soldering method according to claim 1, wherein
as the laser beam, a laser beam of which an output level in a transverse section at an irradiated surface is higher at an outer peripheral part thereof than at a center part thereof is used,
setting is made such that the output level at the center part is lower than a melting temperature of the wire solder, the output level at the outer peripheral part is higher than the melting temperature of the wire solder, and the center part is applied to an inner side of the through hole of the land,
the output level at a time of the preheating is set to a preheating level not higher than the melting temperature of the wire solder, and
the output level at a time of the soldering is set to a melting level not lower than the melting temperature of the wire solder.

6. The laser soldering method according to claim 1, wherein
as the laser beam, a laser beam of which an output level in a transverse section at an irradiated surface is higher at an outer peripheral part thereof than at a center part thereof is used,
setting is made such that the output level at the center part is lower than a melting temperature of the wire solder, the output level at the outer peripheral part is higher than the melting temperature of the wire solder, and the center part is applied to an inner side of the through hole of the land,
at a time of the preheating, the preheating is performed using only the hot wind, and
at a time of starting the soldering, the laser beam is emitted and the output level thereof is set to a melting level not lower than the melting temperature of the wire solder.

7. The laser soldering method according to claim 1, wherein
as the laser beam, a laser beam of which an output level in a transverse section at an irradiated surface is higher at an outer peripheral part thereof than at a center part thereof is used,
setting is made such that the output level at the center part is lower than a melting temperature of the wire solder, the output level at the outer peripheral part is higher than the melting temperature of the wire solder, and the center part is applied to an inner side of the through hole of the land,
at a time of starting the preheating or at a stage during the preheating, the laser beam is emitted, and the output level thereof is gradually increased from zero to a melting level not lower than the melting temperature of the wire solder, and
the output level at a time of the soldering is set to the melting level not lower than the melting temperature of the wire solder.

8. A laser soldering device for soldering a lead of an electronic component to a land of a printed board by a laser beam, the laser soldering device comprising:
a support base configured to support the printed board in a state in which the electronic component is mounted at an upper surface of the printed board and the lead of the electronic component protrudes downward from a through hole of the printed board;
an emission head provided under the printed board so as to be vertical or inclined relative to the printed board, the emission head being configured to emit the laser beam vertically or in an inclined state toward the land;
a wire solder feeding portion configured to feed wire solder to a position contacting with either the land or the lead at a time of soldering;
a hollow protection nozzle provided at an emission port of the emission head and extending from the emission port toward the printed board present upward, the protection nozzle having a pass hole at a tip thereof facing the printed board; and
a heating gas supply pipe provided to the protection nozzle and configured to supply heating gas to the protection nozzle so that a hot wind is blown out from the pass hole toward the printed board.

9. The laser soldering device according to claim 8, further comprising an exhaust duct opened at an upper surface thereof opposed to a lower surface of the printed board, at a position facing the pass hole of the protection nozzle.

10. The laser soldering device according to claim 8, wherein
as the laser beam, either of the following laser beams is used:
a laser beam having an equal output level over an entire area of a transverse section at an irradiated surface; or
a laser beam having a double ring structure having a center part and an outer peripheral part surrounding the center part in a transverse section at an irradiated surface, the laser beam being set such that an output level at the center part is not higher than a melting temperature of the wire solder and an output level at the outer peripheral part is not lower than the melting temperature of the wire solder.

11. The laser soldering device according to claim 8, wherein
the protection nozzle is formed such that a diameter thereof is reduced toward the pass hole, and
the protection nozzle has therein a guide wall for hot wind guide, the guide wall being formed along an inner circumferential surface of the protection nozzle.
